# EUROPEAN PATENT SPECIFICATION

(11) **EP 3 173 806 B1**
(45) Date of publication and mention of the grant of the patent: **10.04.2019**
(21) Application number: 15824755.1
(22) Date of filing: 26.06.2015
(51) Int. Cl.: G01R 33/09, H01L 43/08

(54) **MAGNETIC SENSOR**
MAGNETISCHER SENSOR
CAPTEUR MAGNÉTIQUE

(30) Priority: 24.07.2014 JP 2014150816
(43) Date of publication of application: 31.05.2017
(73) Proprietor: Murata Manufacturing Co., Ltd., Nagaokakyo-shi, Kyoto 617-8555 (JP)
(72) Inventor: MORI, Daisuke, Nagaokakyo-shi Kyoto 617-8555 (JP)
(74) Representative: Reeve, Nicholas Edward
(86) International application number: PCT/JP2015/068469
(87) International publication number: WO 2016/013345

(56) References cited:
- JP-A- S4 898 735
- JP-A- S4 898 735
- JP-A- H03 282 277
- JP-A- H03 282 277
- JP-A- H06 350 159
- JP-A- 2003 282 996
- JP-A- 2003 282 996
- JP-A- 2005 351 656
- JP-A- 2012 088 225
- JP-U- S4 886 765
- US-A- 4 480 248
- US-A- 4 480 248
- US-A1- 2011 037 459

## Description

### Technical Field

The present invention relates to a magnetic sensor and particularly relates to a magnetic sensor that includes a magnetoresistive element.

### Background of the Invention

Japanese Unexamined Patent Application Publication No. 11-274598, Japanese Unexamined Patent Application Publication No. 9-102638, International Publication No. 2013/171977 and Japanese Unexamined Patent Application Publication No. 2012-88225 are related art documents that disclose magnetic sensors that realize an improvement in isotropy in magnetic field detection.

The pattern of a magnetoresistive element of the magnetic sensor disclosed in JP 11-274598 has a spiral shape. The two ends of the spiral-shaped pattern are formed at the outermost parts of the pattern located on opposite sides to each other. The pattern of the magnetoresistive element is substantially formed of just curved portions.

A magnetoresistive element of the magnetic sensor disclosed in JP 9-102638 has a circular shape formed by being wound through a plurality of turns in a spiral shape, and is formed through film deposition so as to be isotropic with respect to an external magnetic field.

In the magnetic sensor disclosed in 2013/171977, each of a plurality of magnetoresistive elements of a bridge circuit is connected so as to be successively folded back, with plural portions that extend in a direction that is substantially orthogonal to the overall magnetic field direction being arrayed in parallel at prescribed intervals, and each of the plural portions is connected so as to be successively folded back, formed in a zigzag state that is electrically connected, with multiple portions that extend in the magnetic field detection direction being arrayed parallel at prescribed intervals.

The magnetic sensor disclosed in JP 2012-88225 is formed by connecting two magnetoresistive elements, which each have a shape formed by continuously connecting semicircular arc-shaped patterns of different diameters, in parallel with each other.

In JP 11-274598 and JP 9-102638, there is no description or suggestion of forming a magnetic sensor by using a plurality of magnetoresistive elements. In the magnetic sensor disclosed in WO 2013/171977, since a plurality of patterns having zig-zag shapes are arranged in parallel with each other, there is room for further improvement in terms of reducing the size of the magnetic sensor. In the magnetic sensor disclosed in JP 2012-88225, wiring lines are routed in three dimensions and the manufacturing process is complex.

The magnetoresistive element disclosed in US 4480248 comprises a first to fourth magnetoresistive parts formed on a substrate. The arrangement is such that when a magnet is moved relative to the magnetoresistive element, the resistance values of the first and second magnetoresistive parts operatively change and the third part is always exposed to a magnetic field, but the fourth part is not exposed.

The detection element of JP H03-282277 comprises a compensating resistor and a detecting resistor. The compensating resistor and detecting resistor are formed from a plurality of short strip like parts were the strips of the compensating resistor are made narrower than the strips of the detecting resistor.

The magnetoresistive elements disclosed in JP S48-86765 and JP S48-98735 comprise a double spiral shaped magnetoresistive element.

The magneto resistive element disclosed in JP 2003-282996 comprises a plurality of rectilinear parts with linear shape, or curved parts, arranged stretch along a first and second direction.

US 2011/0037459 describes a rotation-angle-detecting apparatus comprising a magnet rotor, a magnetic sensor detecting the direction of magnetic flux from the magnetic rotor, a correction circuit and angle calculating circuit, the magnetic sensor having bridge circuits X and Y, each comprising four connected magnetoresistive devices.

In light of the above-described problems, we have appreciated that it would be desirable to provide a compact magnetic sensor that can be easily manufactured.

### SUMMARY OF THE INVENTION

A magnetic sensor based on the present invention includes a plurality of magnetoresistive elements that are electrically connected to each other with wiring lines and form a bridge circuit. The plurality of magnetoresistive elements includes a first magnetoresistive element and a second magnetoresistive element, which form a pair. A rate of change of resistance of the first magnetoresistive element is higher than a rate of change of resistance of the second magnetoresistive element. The first magnetoresistive element includes a plurality of first unit patterns that are arranged along a circumference of an imaginary circle in plan view so as to be arrayed in a circumferential direction or a diameter direction of the imaginary circle, the first unit patterns being connected to each other. The second magnetoresistive element is positioned inside the imaginary circle and is surrounded by the first magnetoresistive element in plan view. The second magnetoresistive element includes a plurality of second unit patterns that are narrower than the plurality of first unit patterns and are connected to each other. Further, the second magnetoresistive element is connected to a wiring line that extends from inside the imaginary circle to outside of the imaginary circle, and the plurality of first unit patterns are positioned along an imaginary C-shape having an open part, along the circumference of the imaginary circle, in which the wiring line is positioned. The magnetic sensor includes two pairs of the first magnetoresistive element and the second magnetoresistive element. Circumferential direction orientations of the two first magnetoresistive elements included in the two pairs of the first magnetoresistive element and the second magnetoresistive element are different from each other such that orientations of the imaginary C-shapes are different from each other.

In an embodiment of the present invention, the second magnetoresistive element includes a double-spiral-shaped pattern that has a double spiral shape in plan view. The double-spiral-shaped pattern includes one spiral-shaped pattern, which is one of the plurality of second unit patterns, another spiral-shaped pattern, which another one of the plurality of second unit patterns, and an S-shaped pattern or a reverse S-shaped pattern that connects the one spiral-shaped pattern and the other spiral-shaped pattern to each other in a central portion of the double-spiral-shaped pattern.

In an embodiment of the present invention, each of the plurality of second unit patterns includes a plurality of bent portions and has a folded back shape, and does not include a linear extending portion having a length of 10 µm or more.

In an embodiment of the present invention, the plurality of second unit patterns are semicircular arc-shaped patterns that are line-symmetrically arranged along a circumference of the imaginary circle so as to be arrayed in a diameter direction of the imaginary circle.

In an embodiment of the present invention, the plurality of second unit patterns are spherical patterns having a diameter of less than 10 µm.

In an embodiment of the present invention, the plurality of first unit patterns are C-shaped patterns that are arranged along the imaginary C-shape so as to be arrayed in a diameter direction of the imaginary circle.

In an embodiment of the present invention, the plurality of first unit patterns are folded-back-shaped patterns that are arranged in a radiating shape that radiates from the center of the imaginary circle.

According to the present invention, a compact magnetic sensor can be easily manufactured.

### BRIEF DESCRIPTION OF DRAWINGS

Fig. 1 is a plan view illustrating the patterns of four magnetoresistive elements that form a bridge circuit of a magnetic sensor according to embodiment 1 of the present invention.
Fig. 2 is an equivalent circuit diagram of the magnetic sensor according to embodiment 1 of the present invention.
Fig. 3 is a sectional view illustrating the multilayer structure of a connection portion between a magnetoresistive element and a wiring line in the bridge circuit of the magnetic sensor according to embodiment 1 of the present invention.
Fig. 4 is a plan view illustrating the pattern of a first magnetoresistive element of the magnetic sensor according to embodiment 1 of the present invention.
Fig. 5 is a plan view illustrating the pattern of a second magnetoresistive element of the magnetic sensor according to embodiment 1 of the present invention.
Fig. 6 is a plan view illustrating a state in which two semicircular arc-shaped patterns are arranged concentrically.
Fig. 7 is a graph illustrating the results of an experiment in which the direction in which an external magnetic field was applied to the magnetic sensor according to embodiment 1 of the present invention among horizontal directions was changed from 0° to 337.5° at intervals of 22.5° and the relationship between the strength of the external magnetic field and the output of the magnetic sensor was obtained.
Fig. 8 is a plan view illustrating the patterns of four magnetoresistive elements that form a bridge circuit of a magnetic sensor according to embodiment 2 of the present invention.
Fig. 9 is a plan view illustrating the pattern of a second magnetoresistive element of the magnetic sensor according to embodiment 2 of the present invention.
Fig. 10 is a plan view illustrating a unit pattern included in the pattern of the second magnetoresistive element of the magnetic sensor according to embodiment 2 of the present invention.
Fig. 11 is a plan view illustrating the patterns of four magnetoresistive elements that form a bridge circuit of a magnetic sensor according to embodiment 3 of the present invention.
Fig. 12 is a plan view illustrating the pattern of a second magnetoresistive element of the magnetic sensor according to embodiment 3 of the present invention.
Fig. 13 is a graph illustrating the results of an experiment in which the direction in which an external magnetic field was applied to the magnetic sensor according to embodiment 3 of the present invention among horizontal directions was changed from 0° to 337.5° at intervals of 22.5° and the relationship between the strength of the external magnetic field and the output of the magnetic sensor was obtained.
Fig. 14 is a plan view illustrating the patterns of four magnetoresistive elements that form a bridge circuit of a magnetic sensor according to embodiment 4 of the present invention.
Fig. 15 is a plan view illustrating the pattern of a first magnetoresistive element of the magnetic sensor according to embodiment 4 of the present invention.
Fig. 16 is a plan view illustrating the pattern of a second magnetoresistive element of the magnetic sensor according to embodiment 4 of the present invention.

### DETAILED DESCRIPTION OF EXAMPLE EMBODIMENTS

Hereafter, magnetic sensors according to embodiments of the present invention will be described while referring to the drawings. In the following description of the embodiments, identical or equivalent parts in the drawings are denoted by the same symbols and repeated description thereof is omitted.

### Embodiment 1

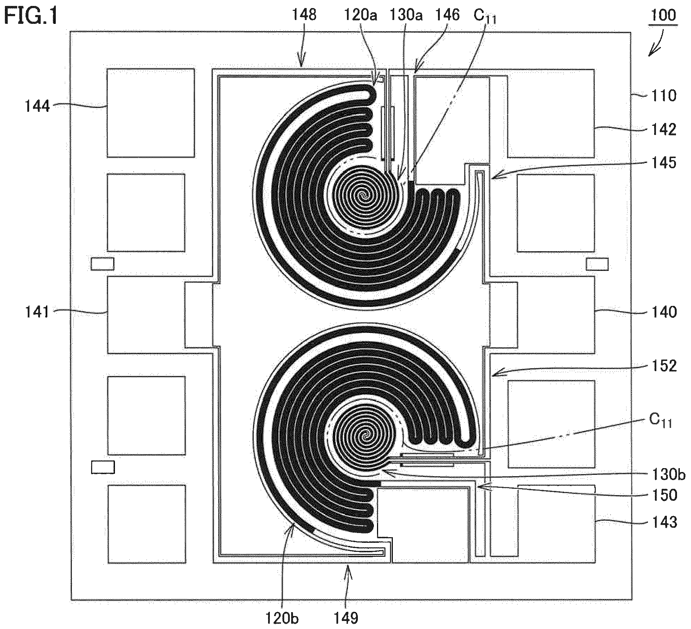

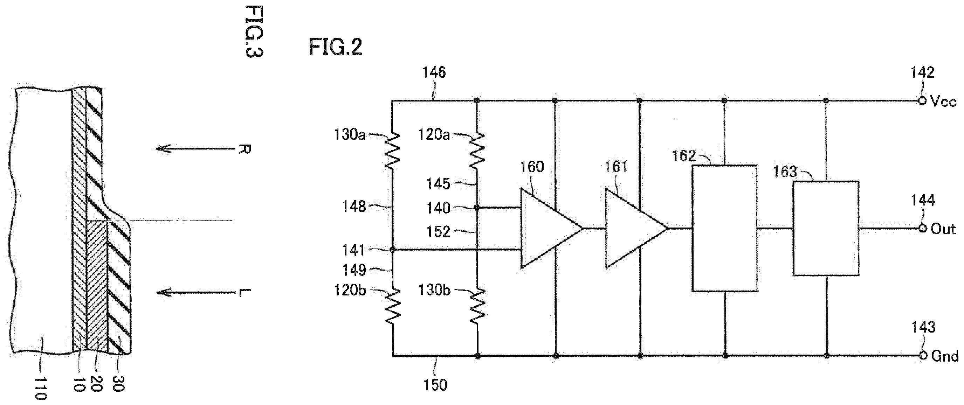

Fig. 1 is a plan view illustrating the patterns of four magnetoresistive elements that form a bridge circuit of a magnetic sensor according to embodiment 1 of the present invention. Fig. 2 is an equivalent circuit diagram of the magnetic sensor according to embodiment 1 of the present invention.

As illustrated in Figs. 1 and 2, a magnetic sensor 100 according to embodiment 1 of the present invention includes four magnetoresistive elements that are electrically connected to each other with wiring lines and form a Wheatstone-bridge-type bridge circuit. The four magnetoresistive elements include two pairs of a first magnetoresistive element and a second magnetoresistive element, which form a pair. Although the magnetic sensor 100 includes two pairs of the first magnetoresistive element and the second magnetoresistive element in this embodiment, the magnetic sensor 100 is not limited to this configuration and it is sufficient that the magnetic sensor 100 include at least one pair of the first magnetoresistive element and the second magnetoresistive element.

Among the two pairs of the first magnetoresistive element and the second magnetoresistive element, the rates of change of resistance of first magnetoresistive elements 120a and 120b are higher than the rates of change of resistance of second magnetoresistive elements 130a and 130b. The first magnetoresistive elements 120a and 120b are so-called magneto-sensitive resistors in which the electrical resistance values thereof change in accordance with an externally applied magnetic field. The second magnetoresistive elements 130a and 130b are fixed resistors in which the electrical resistance values thereof substantially do not change even when an external magnetic field is applied.

The four magnetoresistive elements are electrically connected to each other by wiring lines formed on a substrate 110. Specifically, the first magnetoresistive element 120a and the second magnetoresistive element 130a are connected in series with each other by a wiring line 146. The first magnetoresistive element 120b and the second magnetoresistive element 130b are connected in series with each other by a wiring line 150.

The magnetic sensor 100 has a midpoint 140, a midpoint 141, a power supply terminal (Vcc) 142, a ground terminal (Gnd) 143 and an output terminal (Out) 144 formed on the substrate 110.

The first magnetoresistive element 120a and the second magnetoresistive element 130b are connected to the midpoint 140. Specifically, the first magnetoresistive element 120a and the midpoint 140 are connected to each other by a wiring line 145 and the second magnetoresistive element 130b and the midpoint 140 are connected to each other by a wiring line 152.

The first magnetoresistive element 120b and the second magnetoresistive element 130a are connected to the midpoint 141. Specifically, the first magnetoresistive element 120b and the midpoint 141 are connected to each other by a wiring line 149 and the second magnetoresistive element 130a and the midpoint 141 are connected to each other by a wiring line 148.

The wiring line 146 is connected to the power supply terminal (Vcc) 142 to which a current is input. The wiring line 150 is connected to the ground terminal (Gnd) 143.

As illustrated in Fig. 2, the magnetic sensor 100 further includes a differential amplifier 160, a temperature compensation circuit 161, a latch and switch circuit 162 and a complementary metal oxide semiconductor (CMOS) driver 163.

Input terminals of the differential amplifier 160 are connected to the midpoint 140 and the midpoint 141, and an output terminal of the differential amplifier 160 is connected to the temperature compensation circuit 161. In addition, the differential amplifier 160 is connected to the power supply terminal (Vcc) 142 and the ground terminal (Gnd) 143.

An output terminal of the temperature compensation circuit 161 is connected to the latch and switch circuit 162. In addition, the temperature compensation circuit 161 is connected to the power supply terminal (Vcc) 142 and the ground terminal (Gnd) 143.

An output terminal of the latch and switch circuit 162 is connected to the CMOS driver 163. In addition, the latch and switch circuit 162 is connected to the power supply terminal (Vcc) 142 and the ground terminal (Gnd) 143.

An output terminal of the CMOS driver 163 is connected to the output terminal (Out) 144. Furthermore, the CMOS driver 163 is connected to the power supply terminal (Vcc) 142 and the ground terminal (Gnd) 143.

As a result of the magnetic sensor 100 having the above-described circuit configuration, a potential difference, which depends on the strength of an external magnetic field, is generated between the midpoint 140 and the midpoint 141. When this potential difference exceeds a preset detection level, a signal is output from the output terminal (Out) 144.

Fig. 3 is a sectional view illustrating the multilayer structure of a connection portion between a magnetoresistive element and a wiring line in the bridge circuit of the magnetic sensor according to embodiment 1 of the present invention. Fig. 3 illustrates only a connection portion between a region R, which functions as a magnetoresistive element, and a region L, which functions as a wiring line.

As illustrated in Fig. 3, the four magnetoresistive elements are formed on a substrate 110 that has a SiO₂ layer or a Si₃N₄ layer provided on a surface thereof and that is composed of Si or the like. The four magnetoresistive elements are formed by patterning a magnetic layer 10 provided on the substrate 110 and composed of an alloy including Ni and Fe by performing milling.

A wiring line is formed by patterning a conductive layer 20, which is provided above the substrate 110 and is composed of Au, Al or the like, by performing wet etching. The conductive layer 20 is located directly above the magnetic layer 10 in the region where the magnetic layer 10 is provided and is located directly above the substrate 110 in the region where the magnetic layer 10 is not provided. Therefore, as illustrated in Fig. 3, the conductive layer 20 is located directly above the magnetic layer 10 in the connection portion between the region R functioning as the magnetoresistive element and the region L functioning as the wiring line.

The midpoint 140, the midpoint 141, the power supply terminal (Vcc) 142, the ground terminal (Gnd) 143 and the output terminal (Out) 144 are formed by the conductive layer 20 located directly above the substrate 110.

A Ti layer, which is not illustrated, is provided directly above the conductive layer 20. A protective layer 30, which is composed of SiO₂ or the like, is provided so as to cover the magnetoresistive element and the wiring line.

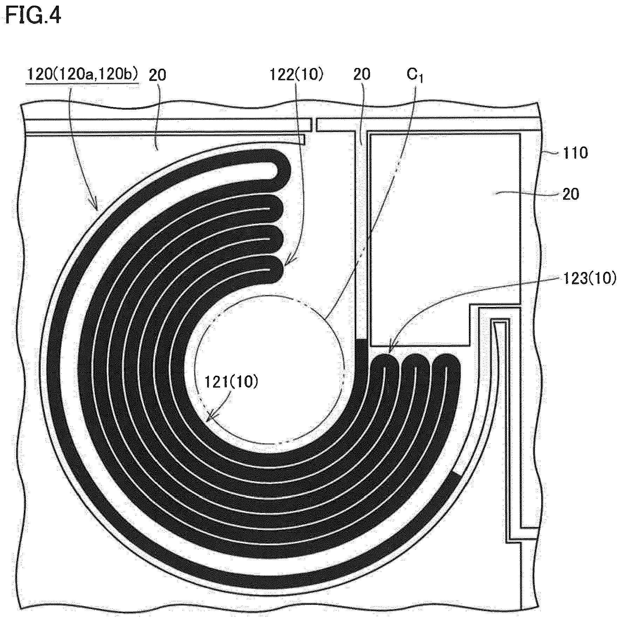

Fig. 4 is a plan view illustrating the pattern of a first magnetoresistive element of the magnetic sensor according to embodiment 1 of the present invention. As illustrated in Figs. 1 and 4, a pattern 120 of the first magnetoresistive elements 120a and 120b includes eight first unit patterns that are arranged along the circumference of an imaginary circle C₁ in plan view so as to be arrayed in a diameter direction of the imaginary circle C₁, the first unit patterns being connected to each other. The eight first unit patterns are positioned along an imaginary C-shape C₁₁ having an open part in the circumference of the imaginary circle C₁ in which the wiring lines 146, 148, 150 and 152 are located. The eight first unit patterns are C-shaped patterns 121 that are arranged along the imaginary C-shape C₁₁ so as to be arrayed in the diameter direction of the imaginary circle C₁.

One ends of every two C-shaped patterns 121, which are adjacent to each other in order from the inner side, are connected to each other by a semicircular arc-shaped pattern 122. Other ends of every two C-shaped patterns 121, which are adjacent to each other in order from the inner side, are connected to each other by a semicircular arc-shaped pattern 123. The pattern 120 of each of first magnetoresistive elements 120a and 120b includes four semicircular arc-shaped patterns 122 and three semicircular arc-shaped patterns 123. The eight C-shaped patterns 121 are thus connected in series with each other. The semicircular arc-shaped patterns 122 and 123 do not include any linear extending portions and are formed of only curved portions.

As illustrated in Fig. 1, the two first magnetoresistive elements 120a and 120b have different orientations in the circumferential direction such that the orientations of the imaginary C-shapes C₁₁ are different from each other. That is, the circumferential direction orientations of the patterns 120 of the 2 first magnetoresistive elements 120a and 120b are different from each other such that the orientations of the C-shaped patterns 121 are different from each other.

In this embodiment, the circumferential direction orientations of the patterns 120 of the two first magnetoresistive elements 120a and 120b differ by 90° such that the orientations of the C-shaped patterns 121 differ by 90°.

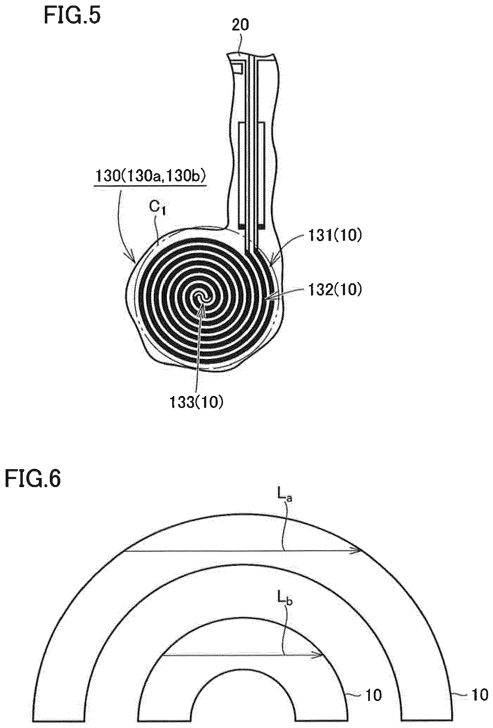

Fig. 5 is a plan view illustrating the pattern of a second magnetoresistive element of the magnetic sensor according to embodiment 1 of the present invention. As illustrated in Figs. 1 and 5, the second magnetoresistive elements 130a and 130b are located inside the imaginary circles C₁ in plan view and are surrounded by the first magnetoresistive elements 120a and 120b. The second magnetoresistive elements 130a and 130b are connected to the wiring lines 146, 148, 150 and 152, which extend from the inside the imaginary circles C₁ to outside the imaginary circles C₁. The second magnetoresistive elements 130a and 130b each include a double-spiral-shaped pattern 130, which has a double spiral shape in plan view.

The double-spiral-shaped pattern 130 includes one spiral-shaped pattern 131, which is one of two second unit patterns, another spiral-shaped pattern 132, which is the other one of the two second unit patterns, and a reverse S-shaped pattern 133 that connects the one spiral-shaped pattern 131 and the other spiral-shaped pattern 132 to each other in a central portion of the double-spiral-shaped pattern 130. The reverse S-shaped pattern 133 does not include any linear extending portions and is formed of only curved portions.

The double-spiral-shaped pattern 130 is formed of a narrower pattern than the pattern 120. Therefore, the one spiral-shaped pattern 131 and the other spiral-shaped pattern 132 are narrower than the eight C-shaped patterns 121.

As illustrated in Fig. 5, the double-spiral-shaped pattern 130 has a shape that substantially exhibits point symmetry about the center of the imaginary circle C₁. That is, the double-spiral-shaped pattern 130 has a shape that substantially exhibits 180° rotational symmetry about the center of the imaginary circle C₁.

As illustrated in Fig. 1, the double-spiral-shaped patterns 130 of the two second magnetoresistive elements 130a and 130b have different orientations in the circumferential direction such that the orientations of the reverse S-shaped patterns 133 thereof are different from each other.

In this embodiment, the circumferential direction orientations of the double-spiral-shaped patterns 130 of the two second magnetoresistive elements 130a and 130b differ by 90° such that the orientations of the reverse S-shaped patterns 133 thereof differ by 90°.

The electrical resistance value of a magnetoresistive element changes due to the magnetoresistive effect when a magnetic field is applied at a specific angle with respect to the direction in which a current flows through the magnetoresistive element. The magnetoresistive effect becomes stronger as the length of a magnetoresistive element in the longitudinal direction thereof increases.

Therefore, as a result of the second magnetoresistive elements 130a and 130b having the above-described patterns, the magnetoresistive effects of the second magnetoresistive elements 130a and 130b are suppressed and the rates of change of resistance of the second magnetoresistive elements 130a and 130b are very small.

The reason for this will be described below. Fig. 6 is a plan view illustrating a state in which two semicircular arc-shaped patterns are arranged concentrically. As illustrated in Fig. 6, a length L_{b}, which is located on a straight line in the semicircular arc-shaped pattern positioned on the inside, is smaller than a length Lₐ, which is located on a straight line in the semicircular pattern positioned on the outside. Consequently, the magnetoresistive effect of the semicircular arc-shaped pattern positioned on the inside is smaller than the magnetoresistive effect of the semicircular arc-shaped pattern positioned on the outside.

Therefore, the magnetoresistive effects of the second magnetoresistive elements 130a and 130b, which are positioned inside the first magnetoresistive elements 120a and 120b, are smaller than the magnetoresistive effects of the first magnetoresistive elements 120a and 120b. As described above, in this embodiment, the double-spiral-shaped patterns 130 of the second magnetoresistive elements 130a and 130b are formed of patterns that are narrower than the patterns 120 of the first magnetoresistive elements 120a and 120b. Therefore, the magnetoresistive effects of the second magnetoresistive elements 130a and 130b become further smaller than the magnetoresistive effects of the first magnetoresistive elements 120a and 120b. As a result, the magnetoresistive effects of the second magnetoresistive elements 130a and 130b are suppressed and the rates of change of resistance of the second magnetoresistive elements 130a and 130b are very small.

In the magnetic sensor 100 according to this embodiment, the first magnetoresistive elements 120a and 120b each include C-shaped patterns 121. The C-shaped patterns 121 are formed of circular arcs. Every two adjacent C-shaped patterns 121 are connected to each other by the semicircular arc-shaped patterns 122 and 123. Thus, since the first magnetoresistive elements 120a and 120b do not include any linear extending portions, the anisotropy of magnetic field detection is reduced.

In addition, in the magnetic sensor 100 according to this embodiment, the patterns 120 have different circumferential direction orientations from each other such that the orientations of the C-shaped patterns 121 of the two first magnetoresistive elements 120a and 120b are different from each other and the isotropy of magnetic field detection is improved.

In the magnetic sensor 100 according to this embodiment, the second magnetoresistive elements 130a and 130b each have a double-spiral-shaped pattern 130. The double-spiral-shaped pattern 130 is principally formed by winding substantially circular arc-shaped curved portions. Since the circular arcs approximately have shapes that are obtained when the number of corners of a polygonal shape increases toward infinity, the direction of the current flowing through the double-spiral-shaped pattern 130 varies across substantially all horizontal directions (360°). The horizontal directions are directions that are parallel to the surface of the substrate 110.

In addition, in the magnetic sensor 100 according to this embodiment, the central portion of the double-spiral-shaped pattern 130 is formed of the reverse S-shaped pattern 133 that is constituted by only curved portions. Thus, since the second magnetoresistive elements 130a and 130b do not include any linear extending portions, the anisotropy of the magnetoresistive effect is reduced.

Furthermore, in the magnetic sensor 100 according to this embodiment, the double-spiral-shaped patterns 130 have different circumferential direction orientations from each other such that the reverse S-shaped patterns 133 of the two second magnetoresistive elements 130a and 130b have different orientations from each other, and as a result the isotropy of the magnetoresistive effect is improved.

The reason for this is as follows. As described above, the double-spiral-shaped pattern 130 has a shape that substantially exhibits 180° rotational symmetry about the center of the imaginary circle C₁. Therefore, the magnetoresistive effects of the two second magnetoresistive elements 130a and 130b have little anisotropy.

Consequently, it is possible to make the anisotropies of the magnetoresistive effects of the second magnetoresistive elements 130a and 130b mutually suppress each other by making the double-spiral-shaped pattern 130 of the second magnetoresistive element 130a and the double-spiral-shaped pattern 130 of the second magnetoresistive element 130b have different circumferential direction orientations.

It is possible to make the anisotropies of the magnetoresistive effects of the second magnetoresistive elements 130a and 130b mutually suppress each other to the maximum extent by making the circumferential direction orientations of the double-spiral-shaped pattern 130 of the second magnetoresistive element 130a and the double-spiral-shaped pattern 130 of the second magnetoresistive element 130b differ by 90°.

In this case, the direction in which the second magnetoresistive element 130a has the highest sensitivity and the direction in which the second magnetoresistive element 130b has the lowest sensitivity are the same, and the direction in which the second magnetoresistive element 130a has the lowest sensitivity and the direction in which the second magnetoresistive element 130b has the highest sensitivity are the same. Therefore, it is possible to suppress variations that occur in the potential difference generated between the midpoint 140 and the midpoint 141 when an external magnetic field is applied to the magnetic sensor 100, the variations depending upon the direction in which the external magnetic field is applied to the magnetic sensor 100.

The shape of the double-spiral-shaped pattern 130 has a high density per unit area. As a result of the second magnetoresistive elements 130a and 130b each including the double-spiral-shaped pattern 130, the resistances of the second magnetoresistive elements 130a and 130b can be increased by increasing the length of the pattern arranged inside the imaginary circle C₁. The higher the electrical resistance values of the second magnetoresistive elements 130a and 130b are, the more the current consumption of the magnetic sensor 100 can be reduced.

As described above, the anisotropy of the magnetoresistive effect of the two second magnetoresistive elements 130a and 130b is reduced by causing the direction of the current that flows through the double-spiral-shaped pattern 130 to vary across the horizontal directions, and as a result, variations in the output of the magnetic sensor 100 that occur when the external magnetic field is zero can be suppressed, the variations being caused by the effect of residual magnetization.

The double-spiral-shaped pattern 130 may be wound in the opposite direction and in this case the central portion of the double-spiral-shaped pattern 130 would be formed of an S-shaped pattern constituted by only curved portions. That is, one spiral-shaped pattern and another spiral-shaped pattern would be connected to each other by an S-shaped pattern.

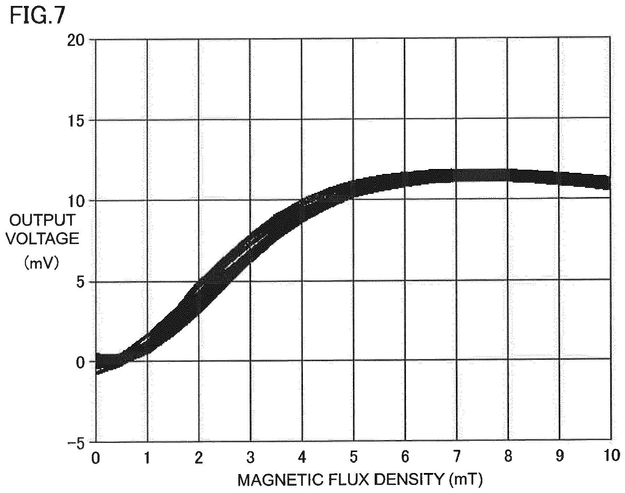

Fig. 7 is a graph illustrating the results of an experiment in which the direction in which an external magnetic field was applied to the magnetic sensor according to embodiment 1 of the present invention among the horizontal directions was changed from 0° to 337.5° at intervals of 22.5° and the relationship between the strength of the external magnetic field and the output of the magnetic sensor was obtained. In Fig. 7, the output voltage (mV) of the magnetic sensor is represented along the vertical axis and the magnetic flux density (mT) is represented along the horizontal axis.

As illustrated in Fig. 7, in the magnetic sensor 100 according to this embodiment, a large change in the relationship between the strength of the external magnetic field and the output of the magnetic sensor 100 could not be recognized even when the direction in which the external magnetic field was applied among horizontal directions was changed from 0° to 337.5° at intervals of 22.5°. In other words, it could be confirmed that the magnetic sensor 100 according to this embodiment has improved isotropy in magnetic field detection. In addition, it could also be confirmed that variations in the output of the magnetic sensor 100 that occur when the external magnetic field is zero are suppressed.

Since the second magnetoresistive elements 130a and 130b are arranged inside the first magnetoresistive elements 120a and 120b in the magnetic sensor 100 according to this embodiment, the magnetic sensor 100 can be made compact. In addition, since there is no need to route the wiring lines that connect the first magnetoresistive elements 120a and 120b and the second magnetoresistive elements 130a and 130b to each other in three dimensions in the magnetic sensor 100, the magnetic sensor 100 can be manufactured using a simple manufacturing process.

Hereafter, a magnetic sensor according to embodiment 2 of the present invention will be described while referring to the drawings. The magnetic sensor according to this embodiment mainly differs from the magnetic sensor 100 according to embodiment 1 in terms of the patterns of the first magnetoresistive elements and the second magnetoresistive elements and therefore repeated description of the rest of the configuration will be omitted.

### Embodiment 2

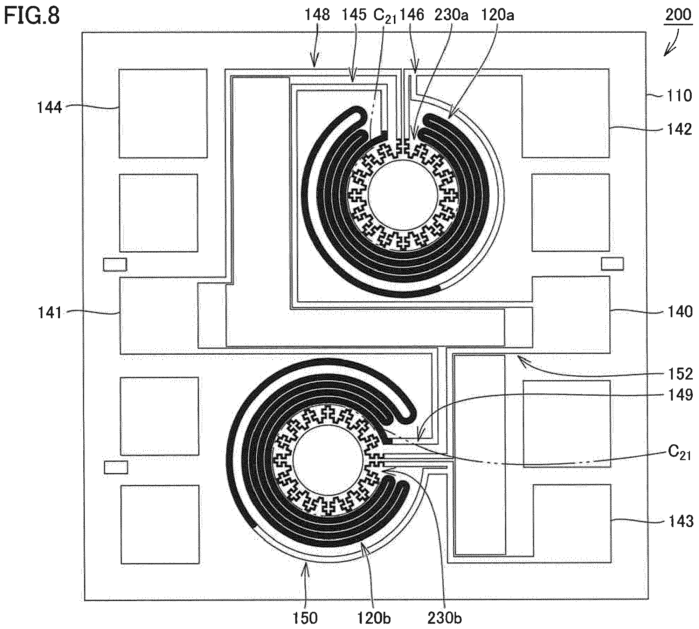

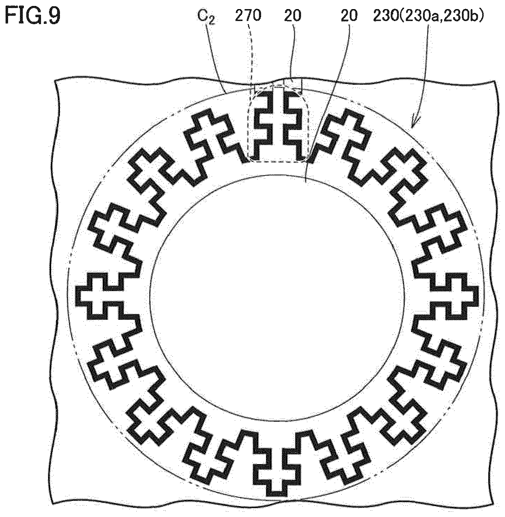

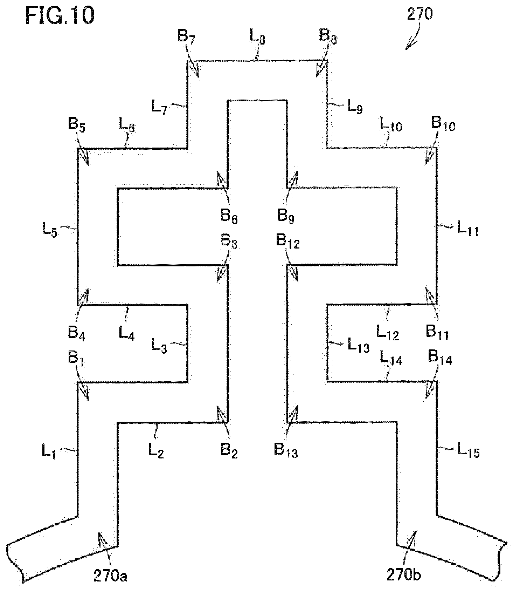

Fig. 8 is a plan view illustrating the patterns of four magnetoresistive elements that form a bridge circuit of a magnetic sensor according to embodiment 2 of the present invention. Fig. 9 is a plan view illustrating the pattern of a second magnetoresistive element of the magnetic sensor according to embodiment 2 of the present invention. Fig. 10 is a plan view illustrating a unit pattern included in the pattern of the second magnetoresistive element of the magnetic sensor according to embodiment 2 of the present invention.

As illustrated in Figs. 8 and 9, the pattern of first magnetoresistive elements 120a and 120b of a magnetic sensor 200 according to embodiment 2 of the present invention includes five first unit patterns that are arranged along the circumference of an imaginary circle C₂ in plan view such that the unit patterns are arrayed in a diameter direction of the imaginary circle C₂, the first unit patterns being connected to each other. The five first unit patterns are positioned along an imaginary C-shape C₂₁ having an open part, in the circumference of the imaginary circle C₂, in which the wiring lines 146, 148, 150 and 152 are located. The five first unit patterns are C-shaped patterns that are arranged along the imaginary C-shape C₂₁ so as to be arrayed in the diameter direction of the imaginary circle C₂.

As illustrated in Fig. 8, the two first magnetoresistive elements 120a and 120b have different orientations in the circumferential direction such that the imaginary C-shapes C₂₁ have different orientations from each other. That is, the circumferential direction orientations of the patterns of the two first magnetoresistive elements 120a and 120b are different from each other such that the orientations of the C-shaped patterns are different from each other.

In this embodiment, the circumferential direction orientations of the patterns of the two first magnetoresistive elements 120a and 120b differ by 90° such that the orientations of the C-shaped patterns differ by 90°.

Second magnetoresistive elements 230a and 230b of the magnetic sensor 200 according to embodiment 2 of the present invention each have a pattern 230 that includes sixteen folded-back second unit patterns 270 that each include a plurality of bent portions. The pattern 230 is formed of a pattern that is narrower than the pattern of the first magnetoresistive elements 120a and 120b.

As illustrated in Fig. 9, the sixteen second unit patterns 270 are arranged along the circumference of the imaginary circle C₂ so as to be arrayed in the circumferential direction of the imaginary circle C₂ and are connected to each other. As illustrated in Fig. 10, each second unit pattern 270 is folded back on itself in a region between a start end portion 270a and a finish end portion 270b and includes fourteen bent portions B1 to B14 and fifteen linear extending portions L₁ to L₁₅. In other words, the second unit pattern 270 has a bag-like shape with the start end portion 270a and the finish end portion 270b being open ends.

In this embodiment, the second unit pattern 270 is bent at right angles in each of the fourteen bent portions B₁ to B₁₄. The second unit pattern 270 does not include any linear extending portions with a length of 10 µm or higher. In other words, the lengths of all fifteen linear extending portions L₁ to L₁₅ are smaller than 10 µm.

Thus, the anisotropy of the magnetoresistive effect of the second magnetoresistive elements 230a and 230b can be reduced by causing the direction of a current flowing through the second unit pattern 270 to vary across the horizontal directions. In addition, variations in the output of the magnetic sensor 200 that occur when the external magnetic field is zero can be suppressed, the variations being caused by the effect of residual magnetization.

In addition, the anisotropy of the magnetoresistive effect of the second magnetoresistive elements 230a and 230b can be reduced by causing the direction of the current that flows through the pattern 230 to vary across the horizontal directions by arranging the plurality of second unit patterns 270 along the circumference of the imaginary circle C₂.

However, the patterns of the second magnetoresistive elements 230a and 230b are not limited to those described above and it is sufficient that the patterns do not include linear extending portions having a length of 10 µm or higher and include a plurality of second unit patterns that are folded back. For example, the second unit patterns 270 may be curved in fourteen bent portions B₁ to B14. In this case, the anisotropy of the magnetoresistive effect of the second magnetoresistive elements 230a and 230b can be further reduced by causing the direction of a current flowing through the second unit pattern 270 to vary across the horizontal directions.

The patterns 230 of the two second magnetoresistive elements 230a and 230b have different orientations from each other in the circumferential direction. In this embodiment, the circumferential direction orientations of the patterns 230 of the two second magnetoresistive elements 230a and 230b differ by 90°. Therefore, the anisotropies of the magnetoresistive effects of the two second magnetoresistive elements 230a and 230b can mutually suppress each other.

Since the second magnetoresistive elements 230a and 230b are arranged inside the first magnetoresistive elements 120a and 120b in the magnetic sensor 200 according to this embodiment as well, the magnetic sensor 200 can also be made compact. In addition, since there is no need to route the wiring lines that connect the first magnetoresistive elements 120a and 120b and the second magnetoresistive elements 230a and 230b to each other in three dimensions in the magnetic sensor 200 as well, the magnetic sensor 200 can also be manufactured using a simple manufacturing process.

Hereafter, a magnetic sensor according to embodiment 3 of the present invention will be described while referring to the drawings. The magnetic sensor according to this embodiment mainly differs from the magnetic sensor 100 according to embodiment 1 in terms of the patterns of the first magnetoresistive elements and the second magnetoresistive elements and therefore repeated description of the rest of the configuration will be omitted.

### Embodiment 3

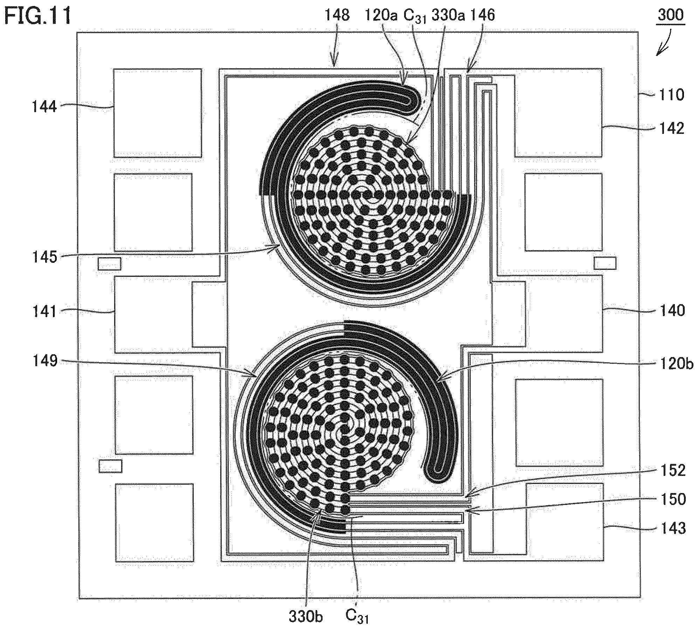

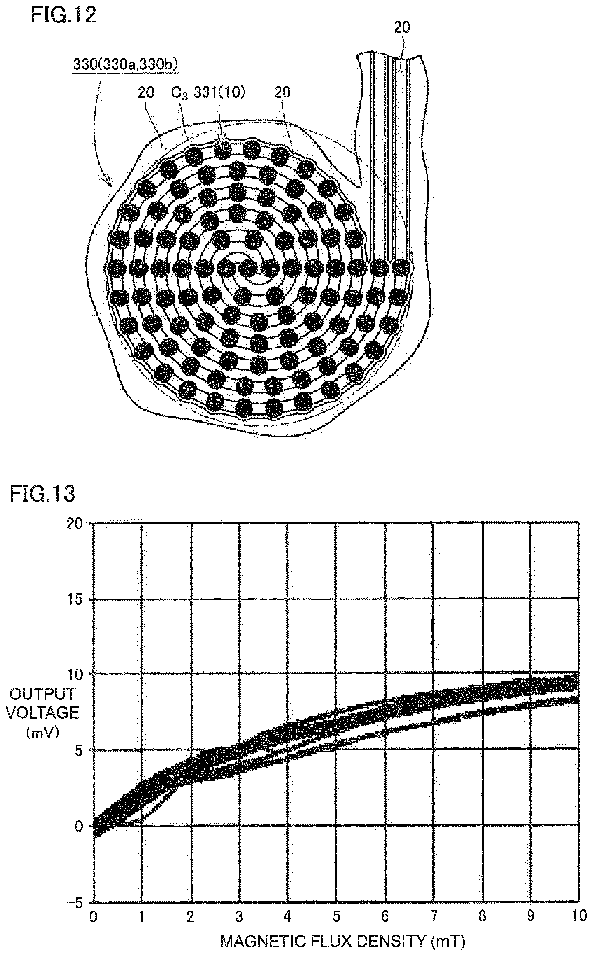

Fig. 11 is a plan view illustrating the patterns of four magnetoresistive elements that form a bridge circuit of a magnetic sensor according to embodiment 3 of the present invention. Fig. 12 is a plan view illustrating the pattern of a second magnetoresistive element of the magnetic sensor according to embodiment 3 of the present invention.

As illustrated in Figs. 11 and 12, the patterns of first magnetoresistive elements 120a and 120b of a magnetic sensor 300 according to embodiment 3 of the present invention each include two first unit patterns that are arranged along the circumference of an imaginary circle C₃ in plan view such that the unit patterns are arrayed in a diameter direction of the imaginary circle C₃, the first unit patterns being connected to each other. The two first unit patterns are positioned along an imaginary C-shape C₃₁ having an open part, along the circumference of the imaginary circle C₃, in which the wiring lines 146, 148, 150 and 152 are located. The two first unit patterns are C-shaped patterns that are arranged along the imaginary C-shape C₃₁ so as to be arrayed in the diameter direction of the imaginary circle C₃.

As illustrated in Fig. 11, the two first magnetoresistive elements 120a and 120b have different orientations in circumferential direction such that the orientations of the imaginary C-shapes C₃₁ are different from each other. That is, the circumferential direction orientations of the patterns of the two first magnetoresistive elements 120a and 120b are different from each other such that the orientations of the C-shaped patterns are different from each other.

In this embodiment, the circumferential direction orientations of the patterns of the two first magnetoresistive elements 120a and 120b differ by 90° such that the orientations of the C-shaped patterns differ by 90°.

Second magnetoresistive elements 330a and 330b of the magnetic sensor 300 according to embodiment 3 of the present invention each have a pattern 330 that includes a plurality of second unit patterns. The plurality of second unit patterns are spherical patterns 331 that have a diameter of less than 10 µm. The plurality of spherical patterns 331 are arrayed in a double spiral shape with spaces therebetween. The plurality of spherical patterns 331 are connected to each other by wiring lines. The spaces between the spherical patterns 331 are preferably as small as possible. The diameter dimension of each of the plurality of spherical patterns 331 is smaller than the width dimension of the patterns of the first magnetoresistive elements 120a and 120b.

Since the length of each spherical pattern 331 along a straight line is the same in all horizontal directions (360°), the pattern 330 is formed of a plurality of spherical patterns 331 having a diameter of less than 10 µm, and as a result the anisotropies of the magnetoresistive effects of the second magnetoresistive elements 330a and 330b can be reduced. Furthermore, the direction in which a current flows through the spherical patterns 331 can be made to vary throughout substantially all horizontal directions (360°) by arranging the plurality of spherical patterns 331 so as to be arrayed in a double spiral shape.

As described above, the anisotropy of the magnetoresistive effect of the second magnetoresistive elements 330a and 330b is reduced by causing the direction of the current that flows through the pattern 330 to vary across the horizontal directions, and as a result, variations in the output of the magnetic sensor 300 that occur when the external magnetic field is zero can be suppressed, the variations being caused by the effect of residual magnetization.

The patterns 330 of the two second magnetoresistive elements 330a and 330b have different circumferential direction orientations from each other. In this embodiment, the circumferential direction orientations of the patterns 330 of the two second magnetoresistive elements 330a and 330b differ by 90°. Therefore, the anisotropies of the magnetoresistive effects of the two second magnetoresistive elements 330a and 330b can mutually suppress each other.

Fig. 13 is a graph illustrating the results of an experiment in which the direction in which an external magnetic field was applied to the magnetic sensor according to embodiment 3 of the present invention among the horizontal directions was changed from 0° to 337.5° at intervals of 22.5° and the relationship between the strength of the external magnetic field and the output of the magnetic sensor was obtained. In Fig. 13, the output voltage (mV) of the magnetic sensor is represented along the vertical axis and the magnetic flux density (mT) is represented along the horizontal axis.

As illustrated in Fig. 13, in the magnetic sensor 300 according to this embodiment, a large change in the relationship between the strength of the external magnetic field and the output of the magnetic sensor 300 could not be recognized even when the direction in which the external magnetic field was applied among the horizontal directions was changed from 0° to 337.5° at intervals of 22.5°. In other words, it could be confirmed that the magnetic sensor 300 according to this embodiment has improved isotropy in magnetic field detection. In addition, it could also be confirmed that variations in the output of the magnetic sensor 300 that occur when the external magnetic field is zero are suppressed. In addition, in the magnetic sensor 300 according to this embodiment, it could be confirmed that the strength of the external magnetic field and the output of the magnetic sensor 300 are substantially linearly proportional to each other.

Since the second magnetoresistive elements 330a and 330b are arranged inside the first magnetoresistive elements 120a and 120b in the magnetic sensor 300 according to this embodiment as well, the magnetic sensor 300 can also be made compact. In addition, since there is no need to route the wiring lines that connect the first magnetoresistive elements 120a and 120b and the second magnetoresistive elements 330a and 330b to each other in three dimensions in the magnetic sensor 300 as well, the magnetic sensor 300 can also be manufactured using a simple manufacturing process.

Hereafter, a magnetic sensor according to embodiment 4 of the present invention will be described while referring to the drawings. A magnetic sensor 400 according to this embodiment mainly differs from the magnetic sensor 100 according to embodiment 1 in terms of the patterns of the first magnetoresistive elements and the second magnetoresistive elements and therefore repeated description of the rest of the configuration will be omitted.

### Embodiment 4

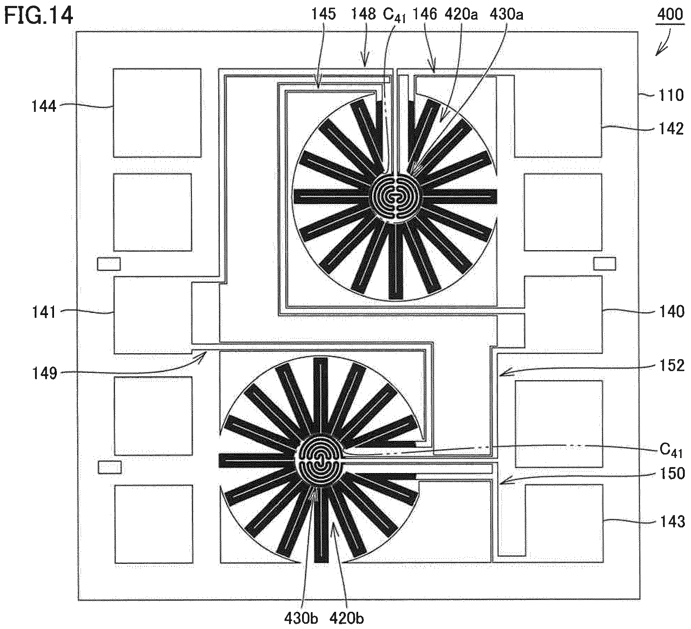

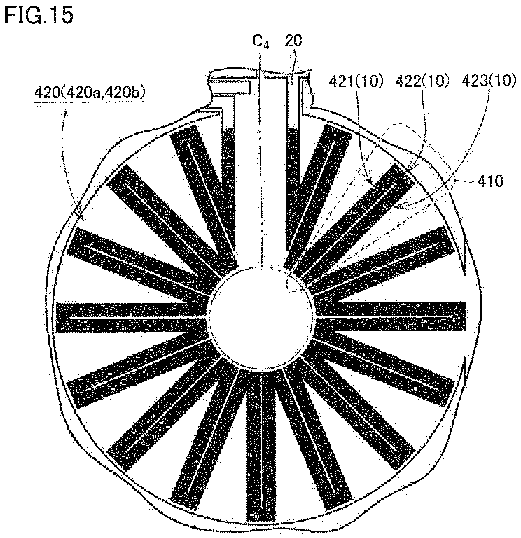

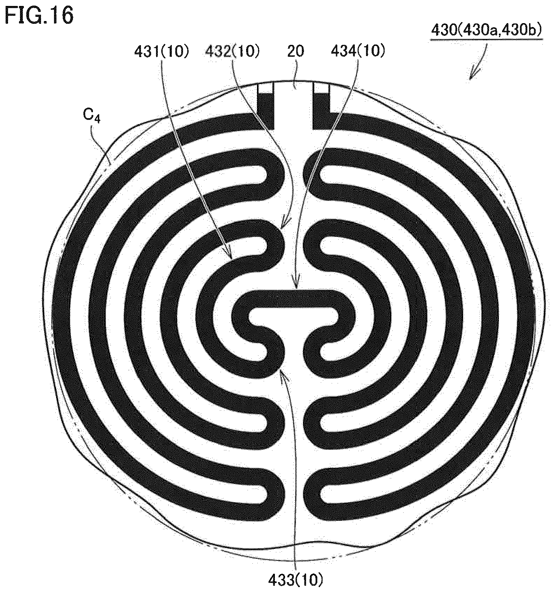

Fig. 14 is a plan view illustrating the patterns of four magnetoresistive elements that form a bridge circuit of the magnetic sensor according to embodiment 4 of the present invention. Fig. 15 is a plan view illustrating the pattern of a first magnetoresistive element of the magnetic sensor according to embodiment 4 of the present invention. Fig. 16 is a plan view illustrating the pattern of a second magnetoresistive element of the magnetic sensor according to embodiment 4 of the present invention.

As illustrated in Figs. 14 and 15, the patterns of first magnetoresistive elements 420a and 420b of the magnetic sensor 400 according to embodiment 4 of the present invention each include fifteen first unit patterns 410 that are arranged, in plan view, along the circumference of an imaginary circle C₄ such that the unit patterns are arrayed in a circumferential direction of the imaginary circle C₄, the first unit patterns being connected to each other. The fifteen first unit patterns 410 are positioned along an imaginary C-shape C₄₁ having an open part, in the circumference of the imaginary circle C₄, in which the wiring lines 146, 148, 150 and 152 are located. The fifteen first unit patterns 410 are folded-back-shaped patterns that are arranged in a radiating shape that radiates from the center of the imaginary circle C₄.

Each folded-back-shaped pattern includes linear extending portions 421 and 423 that extend in a radiating shape that radiates from the center of the imaginary circle C₄ with a space therebetween and a linear extending portion 422 that connects a leading end of the linear extending portion 421 and a leading end of the linear extending portion 423. The linear extending portion 421 and the linear extending portion 422 are orthogonal to each other. The linear extending portion 423 and the linear extending portion 422 are orthogonal to each other.

As illustrated in Fig. 14, the two first magnetoresistive elements 420a and 420b have different orientations from each other in the circumferential direction such that the orientations of the imaginary C-shapes C₄₁ are different from each other. In other words, the patterns 420 of the two first magnetoresistive elements 420a and 420b have different circumferential direction orientations from each other. In this embodiment, the circumferential direction orientations of the patterns 420 of the two first magnetoresistive elements 420a and 420b differ by 90°.

The second magnetoresistive elements 430a and 430b of the magnetic sensor 400 according to embodiment 4 of the present invention each have a pattern 430 that includes twelve semicircular arc-shaped patterns 431, which are second patterns that are line-symmetrically arranged along the circumference of the imaginary circle C₄ so as to be arrayed in a diameter direction of the imaginary circle C₄. The pattern 430 is formed of a pattern that is narrower than the pattern 420 of the first magnetoresistive elements 420a and 420b.

Among the ten semicircular arc-shaped patterns 431 that are located outside the innermost semicircular arc-shaped patterns 431, one ends of every two semicircular arc-shaped patterns 431, which are adjacent to each other in order from the inside, are connected to each other by a semicircular arc-shaped pattern 432. The other ends of every two C-shaped patterns 431, which are adjacent to each other in order from the inside, are connected to each other by a semicircular arc-shaped pattern 433. The one ends of the line-symmetrical innermost semicircular arc-shaped patterns 431 are connected to each other by a linear extending portion 434. The length of the linear extending portion 434 is less than 10 µm.

The patterns 430 of the second magnetoresistive elements 430a and 430b each include four semicircular arc-shaped patterns 432, six semicircular arc-shaped patterns 433 and the linear extending portion 434. The twelve semicircular arc-shaped patterns 431 are thus connected in series with each other. The semicircular arc-shaped patterns 432 and 433 do not include any linear extending portions and are formed of only curved portions.

In addition, in the magnetic sensor 400 according to this embodiment, the anisotropy of the magnetoresistive effect of the first magnetoresistive elements 420a and 420b can be reduced by causing the direction of the current that flows through the pattern 420 to be vary across the horizontal directions by arranging fifteen first unit patterns 410 along the circumference of the imaginary circle C₄.

In the magnetic sensor 400 according to this embodiment, the second magnetoresistive elements 430a and 430b each include semicircular arc-shaped patterns 431. Each semicircular arc-shaped pattern 431 is formed of a circular arc. Every two adjacent semicircular arc-shaped patterns 431 are connected to each other by the semicircular arc-shaped patterns 432 and 433. Since the second magnetoresistive elements 430a and 430b include only the linear extending portion 434, which has a length less than 10 µm, the anisotropy of magnetic field detection is reduced.

The patterns 430 of the two second magnetoresistive elements 430a and 430b have different orientations in the circumferential direction from each other. In this embodiment, the circumferential direction orientations of the patterns 430 of the two second magnetoresistive elements 430a and 430b differ by 90°. Therefore, the anisotropies of the magnetoresistive effects of the two second magnetoresistive elements 430a and 430b can mutually suppress each other.

Since the second magnetoresistive elements 430a and 430b are arranged inside the first magnetoresistive elements 420a and 420b in the magnetic sensor 400 according to this embodiment as well, the magnetic sensor 400 can also be made compact. In addition, since there is no need to route the wiring lines that connect the first magnetoresistive elements 420a and 420b and the second magnetoresistive elements 430a and 430b to each other in three dimensions in the magnetic sensor 400 as well, the magnetic sensor 400 can also be manufactured using a simple manufacturing process.

The presently disclosed embodiments are illustrative in all points and should not be considered as limiting. The scope of the present invention is not defined by the above description but rather by the scope of the claims.

### Reference Signs List

10 magnetic layer, 20 conductive layer, 30 protective layer, 100, 200, 300, 400 magnetic sensor, 110 substrate, 120, 230, 330, 420, 430 pattern, 120a, 120b, 420a, 420b, 430a, 430b first magnetoresistive element, 121, 133 C-shaped pattern, 122, 123, 431, 432, 433 semicircular arc-shaped pattern, 130 double-spiral-shaped pattern, 130a, 130b, 230a, 230b, 330a, 330b, 420a, 420b, 430a, 430b second magnetoresistive element, 131, 132 spiral-shaped pattern, 140, 141 midpoint, 145, 146, 148, 149, 150, 152 wiring line, 160 differential amplifier, 161 temperature compensation circuit, 162 switch circuit, 163 driver, 270 second unit pattern, 270a start end portion, 270b finish end portion, 331 spherical pattern, 410 first unit pattern, 421, 422, 423, 434, L₁-L₁₅ linear extending portion, B₁-B₁₄ curved portion, C₁, C₂, C₃, C₄ imaginary circle, C₁₁, C₂₁, C₃₁, C₄₁ C-shape

## Claims

1. A magnetic sensor (100) comprising:
a plurality of magnetoresistive elements (120a, 130a) that are electrically connected to each other with wiring lines and form a bridge circuit;
wherein the plurality of magnetoresistive elements includes a first magnetoresistive element (120a) and a second magnetoresistive element (130a), which form a pair (120a & 130a),
a rate of change of resistance of the first magnetoresistive element is higher than a rate of change of resistance of the second magnetoresistive element,
the first magnetoresistive element (120a) includes a plurality of first unit patterns that are arranged along a circumference of an imaginary circle (C₁₁) in plan view so as to be arrayed in a circumferential direction or a diameter direction of the imaginary circle (C₁₁), the first unit patterns being connected to each other,
the second magnetoresistive element (130a) is positioned inside the imaginary circle (C₁₁) and is surrounded by the first magnetoresistive element (120a) in plan view,
wherein the second magnetoresistive element (130a) includes a plurality of second unit patterns that are narrower than the plurality of first unit patterns and are connected to each other,
wherein the second magnetoresistive element (130a) is connected to a wiring line that extends from inside the imaginary circle to outside the imaginary circle,
the plurality of first unit patterns are positioned along an imaginary C-shape having an open part, along the circumference of the imaginary circle, in which the wiring line is positioned,
**characterised in that** there are two pairs (120a & 130a, 120b & 130b) of magnetoresistive elements, each comprising a first (120a, 120b) and a second magnetoresistive element (130a, 130b), and
circumferential direction orientations of the two first magnetoresistive elements of the two pairs are different from each other such that orientations of the imaginary C-shapes are different from each other.

2. The magnetic sensor according to claim 1,
wherein the second magnetoresistive element (130a, 130b) includes a double-spiral-shaped pattern that has a double spiral shape in plan view,
the double-spiral-shaped pattern includes one spiral-shaped pattern, which is one of the plurality of second unit patterns, another spiral-shaped pattern, which another one of the plurality of second unit patterns, and an S-shaped pattern or a reverse S-shaped pattern that connects the one spiral-shaped pattern and the other spiral-shaped pattern to each other in a central portion of the double-spiral-shaped pattern.

3. The magnetic sensor according to claim 1,
wherein each of the plurality of second unit patterns includes a plurality of bent portions and has a folded back shape, and does not include a linear extending portion having a length of 10 µm or more.

4. The magnetic sensor according to claim 1,
wherein the plurality of second unit patterns are semicircular arc-shaped patterns that are line-symmetrically arranged along a circumference of the imaginary circle (C₁₁) so as to be arrayed in a diameter direction of the imaginary circle (C₁₁).

5. The magnetic sensor according to claim 1,
wherein the plurality of second unit patterns are spherical patterns having a diameter of less than 10 µm.

6. The magnetic sensor according to claim 1,
wherein the plurality of first unit patterns are C-shaped patterns that are arranged along the imaginary C-shape so as to be arrayed in a diameter direction of the imaginary circle (C₁₁).

7. The magnetic sensor according to claim 1,
wherein the plurality of first unit patterns are folded-back-shaped patterns that are arranged in a radiating shape that radiates from the center of the imaginary circle (C₁₁).

## Patentansprüche

1. Magnetsensor (100), der Folgendes umfasst:
mehrere magnetoresistive Elemente (120a, 130a), die über Verdrahtungsleitungen elektrisch miteinander verbunden sind und eine Brückenschaltung bilden;
wobei die mehreren magnetoresistiven Elemente ein erstes magnetoresistives Element (120a) und ein zweites magnetoresistives Element (130a) beinhalten, die ein Paar (120a & 130a) bilden,
wobei eine Widerstandsänderungsrate des ersten magnetoresistiven Elements höher ist als eine Widerstandswiderungsrate des zweiten magnetoresistiven Elements,
wobei das erste magnetoresistive Element (120a) mehrere erste Einheitsmuster beinhaltet, die entlang einem Umfang eines imaginären Kreises (C₁₁) im Grundriss angeordnet sind, um in einer Umfangsrichtung oder einer Durchmesserrichtung des imaginären Kreises (C₁₁) aufgereiht zu sein, wobei die ersten Einheitsmuster miteinander verbunden sind,
wobei das zweite magnetoresistive Element (130a) innerhalb des imaginären Kreises (C₁₁) positioniert ist und vom ersten magnetoresistiven Element (120a) im Grundriss umgeben ist,
wobei das zweite magnetoresistive Element (130a) mehrere zweite Einheitsmuster beinhaltet, die schmäler sind als die mehreren ersten Einheitsmuster und die miteinander verbunden sind,
wobei das zweite magnetoresistive Element (130a) mit einer Verdrahtungsleitung verbunden ist, die von innerhalb des imaginären Kreises aus dem imaginären Kreises hinaus verläuft,
wobei die mehreren ersten Einheitsmuster entlang einer imaginären C-Form mit einem offenen Teil, entlang dem Umfang des imaginären Kreises positioniert sind, in dem die Verdrahtungsleitung positioniert ist,
**dadurch gekennzeichnet, dass**
es zwei Paare (120 & 130a, 120b & 130b) von magnetoresistiven Elementen gibt, die jeweils ein erstes (120a, 120b) und ein zweites magnetoresistives Element (130a, 130b) umfassen, und
Umfangsrichtungsorientierungen der beiden ersten magnetoresistiven Elemente der beiden Paare sich voneinander unterscheiden, so dass Orientierungen der imaginären C-Formen sich voneinander unterscheiden.

2. Magnetsensor nach Anspruch 1,
wobei das zweite magnetoresistive Element (130a, 130b) ein doppelspiralförmiges Muster aufweist, das eine Doppelspiralform im Grundriss hat,
wobei das doppelspiralförmige Muster ein spiralförmiges Muster aufweist, das eines von mehreren zweiten Einheitsmustern ist, ein anderes spiralförmiges Muster, das ein anderes der mehreren zweiten Einheitsmuster ist, und ein S-förmiges Muster oder ein umgekehrtes S-förmiges Muster, das das eine spiralförmige Muster und das andere spiralförmige Muster miteinander in einem mittleren Abschnitt des doppelspiralförmigen Musters verbindet.

3. Magnetsensor nach Anspruch 1,
wobei jedes der mehreren zweiten Einheitsmuster mehrere gebogene Abschnitte und eine umgeschlagene Form aufweist und keinen linear verlaufenden Abschnitt mit einer Länge von 10 µm oder mehr hat.

4. Magnetsensor nach Anspruch 1,
wobei die mehreren zweiten Einheitsmuster halbkreisförmige bogenförmige Muster sind, die liniensymmetrisch um einen Umfang des imaginären Kreises (C₁₁) angeordnet sind, so dass sie in einer Durchmesserrichtung des imaginären Kreises (C₁₁) aufgereiht sind.

5. Magnetsensor nach Anspruch 1,
wobei die mehreren zweiten Einheitsmuster sphärische Muster mit einem Durchmesser von weniger als 10 µm sind.

6. Magnetsensor nach Anspruch 1,
wobei die mehreren ersten Einheitsmuster C-förmige Muster sind, die entlang der imaginären C-Form angeordnet sind, so dass sie in einer Durchmesserrichtung des imaginären Kreises (C₁₁) aufgereiht sind.

7. Magnetsensor nach Anspruch 1,
wobei die mehreren ersten Einheitsmuster umgeschlagene Muster sind, die in einer Strahlungsform angeordnet sind, die von der Mitte des imaginären Kreises (C₁₁) ausgehend strahlt.

## Revendications

1. Capteur magnétique (100) comprenant :
une pluralité d'éléments magnétorésistifs (120a, 130a) qui sont connectés électriquement les uns aux autres par des lignes de câblage et forment un circuit pont ;
dans lequel la pluralité d'éléments magnétorésistifs comporte un premier élément magnétorésistif (120a) et un second élément magnétorésistif (130a), lesquels forment une paire (120a & 130a),
un taux de changement de résistance du premier élément magnétorésistif est supérieur à un taux de changement de résistance du second élément magnétorésistif,
le premier élément magnétorésistif (120a) comporte une pluralité de premiers motifs unitaires qui sont agencés le long d'une circonférence d'un cercle imaginaire (C₁₁) en vue en plan de manière à être répartis dans un sens de circonférence ou un sens de diamètre du cercle imaginaire (C₁₁), les premiers motifs unitaires étant connectés les uns aux autres,
le second élément magnétorésistif (130a) est positionné à l'intérieur du cercle imaginaire (C11) et est entouré par le premier élément magnétorésistif (120a) en vue en plan,
dans lequel le second élément magnétorésistif (130a) comporte une pluralité de seconds motifs unitaires qui sont plus étroits que la pluralité de premiers motifs unitaires et sont connectés les uns aux autres,
dans lequel le second élément magnétorésistif (130a) est connecté à une ligne de câblage qui s'étend depuis l'intérieur du cercle imaginaire vers l'extérieur du cercle imaginaire,
la pluralité de premiers motifs unitaires est positionnée le long d'une forme de C imaginaire ayant une partie ouverte, le long de la circonférence du cercle imaginaire, dans lequel la ligne de câblage est positionnée,
**caractérisé en ce que**
il existe deux paires (120a & 130a, 120b & 130b) d'éléments magnétorésistifs, chacune comprenant un premier (120a, 120b) et un second élément magnétorésistif (130a, 130b), et
des orientations dans le sens de circonférence des deux premiers éléments magnétorésistifs des deux paires sont différentes l'une de l'autre de telle sorte que des orientations des formes de C imaginaires soient différentes l'une de l'autre.

2. Capteur magnétique selon la revendication 1,
dans lequel le second élément magnétorésistif (130a, 130b) comporte un motif en forme de double spirale qui présente une forme de double spirale en vue en plan,
le motif en forme de double spirale comporte un motif en forme de spirale, lequel est l'un de la pluralité de seconds motifs unitaires, un autre motif en forme de spirale, lequel est un autre de la pluralité de seconds motifs unitaires, et un motif en forme de S ou un motif en forme de S inversé qui connecte le motif en forme de spirale et l'autre motif en forme de spirale l'un à l'autre dans une partie centrale du motif en forme de double spirale.

3. Capteur magnétique selon la revendication 1,
dans lequel chacun de la pluralité de seconds motifs unitaires comporte une pluralité de parties coudées et présente une forme repliée, et ne comporte pas de partie s'étendant linéairement d'une longueur de 10 µm ou plus.

4. Capteur magnétique selon la revendication 1,
dans lequel la pluralité de seconds motifs unitaires est constituée par des motifs en forme d'arc semi-circulaire qui sont agencés avec une symétrie de lignes le long d'une circonférence du cercle imaginaire (C₁₁) de manière à être répartis dans un sens de diamètre du cercle imaginaire (C₁₁).

5. Capteur magnétique selon la revendication 1,
dans lequel la pluralité de seconds motifs unitaires est constituée par des motifs sphériques d'un diamètre de moins de 10 µm.

6. Capteur magnétique selon la revendication 1,
dans lequel la pluralité de premiers motifs unitaires est constituée par des motifs en forme de C qui sont agencés le long de la forme de C imaginaire de manière à être répartis dans un sens de diamètre du cercle imaginaire (C11).

7. Capteur magnétique selon la revendication 1,
dans lequel la pluralité de premiers motifs unitaires est constituée par des motifs de forme repliée qui sont agencés dans une forme rayonnante qui rayonne depuis le centre du cercle imaginaire (C₁₁).
